Europäisches Patentamt

European Patent Office

Office européen des brevets

(11) Publication number: **0 284 214**
**A1**

## EUROPEAN PATENT APPLICATION

(21) Application number: 88301658.6

(51) Int. Cl.⁴: **G01R 15/07**

(22) Date of filing: 26.02.88

(30) Priority: 26.02.87 GB 8704539

(43) Date of publication of application:
28.09.88 Bulletin 88/39

(84) Designated Contracting States:
AT BE CH DE FR GB IT LI LU NL SE

(71) Applicant: BICC Public Limited Company
Devonshire House Mayfair Place
London W1X 5FH(GB)

(72) Inventor: Rees Jones, Gordon, Dr.
17, Bramstage Close Heswell
Wirral Merseyside L60 1YE(GB)

(74) Representative: Gadsden, Robert Edward et al
BICC plc Group Patents & Licensing Dept.
Network House 1, Ariel Way
London W12 7SL(GB)

(54) Electric current measurement.

(57) The magnitude of an electric current i can be determined by passing the current through a source such as a light emitting diode (1), the source being such that the distributed spectral content of the polychromatic light emitted thereby is dependent on the magnitude of the current i being passed therethrough. A detector (4) detects the intensity of the light emitted by the source at a plurality of different wavelengths, and a microprocessor (7) interprets the output of the detector in terms of the current passing through the source.

Fig.1

## ELECTRIC CURRENT MEASUREMENT

This invention relates to the measurement of an electric current. Basic current measurements can be made by measuring the voltage drop across a known resistance. More sophisticated apparatus for measuring a current includes the well known moving coil ammeter, in which the current is used to produce a magnetic field in order to deflect a pointer or the like.

The present invention provides an optical method of accurately measuring the magnitude of an electric current.

Accordingly there is provided apparatus for measuring the magnitude of an electric current comprising a source through which the current to be measured is passed, the source being caused to emit polychromatic light in response to the passage of the current, the source being such that the distributed spectral content of the emitted polychromatic light is dependent on the magnitude of the current being passed therethrough; a detector disposed such that at least some of the emitted polychromatic light is incident thereon, the detector being adapted to detect the intensity of the incident light at a plurality of different wavelengths; and analysis means for interpreting the output of the detector in terms of the current passing through the source.

Conveniently the detector is adapted to monitor the ratio of incident light intensities at two or more separate predetermined wavelengths. This will give an indication of the colour of the light emitted by the source and hence the magnitude of the electric current passing therethrough.

Preferably the detector comprises at least first and second photo-responsive elements, the responsivity with respect to wavelength of the first element being different from that of the second, signals from the photo-responsive elements being fed to the analysis means which calculates, from the signals from the photo-responsive elements, the colour of the polychromatic light incident on the detector as represented by two or more parameters on the Chromaticity (CIE) Diagram. In one convenient arrangement two different photo-responsive elements are employed, each with its own wavelength responsivity characteristic. Alternatively, one or both of the photo-responsive elements includes a coloured filter to impart a colour response characteristic, thereby allowing two identical photo-responsive elements to be employed, if desired. Preferably the responsivity with respect to wavelength/intensity curves overlap for at least a part of the wavelength spectrum.

By employing at least first and second photo-responsive elements, a change of colour is determined by assessing the change in the whole of a selected part of the spectrum (colour modulation) as opposed to merely detecting the change at two or more selected wavelengths (wavelength modulation). Thus a change from colour A (represented by wavelength/intensity curve A) to colour B (represented by wavelength/intensity curve B) will be calculted from the area between the two curves, thereby giving a more complete analysis of 'true' colour. Wavelength modulation is less sophisticated in that it is a calculation based on the distance between the curves at two or more selected wavelengths.

By the term 'polychromatic light' there is herein meant any multi-wavelength radiation, and is specifically meant to include both visible light and infra-red radiation. The term 'colour', whilst used herein for ease of understanding, should in no way imply that only visible light may be employed. Where the apparatus employs a source emitting radiation outside of the visible spectrum, the term 'colour' will refer to the spectral distribution of the radiation.

Preferably the souce is a light emitting diode. In an alternative arrangement the source comprises a plurality of light emitting diodes together with an optical coupler. The current to be measured is passed through one or more of the light emitting diodes thereby changing the distributed spectral content of the combined polychromatic light emerging from the optical coupler.

Conveniently there is provided a display unit actuated by an output signal produced by the analysis means. In this way a continuous display may be given, e.g., on a LED or liquid crystal display, of the magnitude of the current to be measured. Alternatively or additionally the analysis means may provide control signals depending on the magnitude of the electric current in order to regulate other equipment such as electric motors, switchgear etc.

An optical fibre is conveniently provided between the source and the detector, to transmit the coloured light therebetween.

The invention further resides in a method of measuring the magnitude of an electric current employing apparatus as hereinbefore described. In particular, a method of measuring the magnitude of an electric current comprises passing the electric current through a source so as to cause the source to emit polychromatic light; detecting the intensity of the emitted polychromatic light at a plurality of different wavelengths; and interpretting the detected intensity of the polychromatic light in terms of the electric current passing through the source.

The method conveniently includes the step of monitoring the ratio of incident light intensities at two or more separate predetermined wavelengths. Alternatively the method includes the steps of detecting the emitted polychromatic light with a detector comprising at least first and second photo-responsive elements, the responsivity with respect to wavelength of the first element being different from that of the second; calculating, from the output of the first and second photo-responsive elements, the colour of the emitted polychromatic light as represented by two or more parameters on the Chromaticity (CIE) Diagram; and interpreting the colour of the emitted polychromatic light in terms of the electric current passing through the source.

The invention will now be further described, by way of example only, with reference to the accompanying drawings, in which;

Figure 1 is a schematic diagram of current measuring apparatus according to the invention;

Figure 2 is a schematic diagram showing how the apparatus of Figure 1 can be used to measure voltage;

Figure 3 is a schematic diagram showing how the apparatus of Figure 1 can be used to measure a magnetic field;

Figure 4 is a schematic diagram showing how the apparatus of Figure 1 can be used to measure an alternating current; and

Figure 5 is a schematic diagram showing an alternative embodiment of apparatus according to the invention.

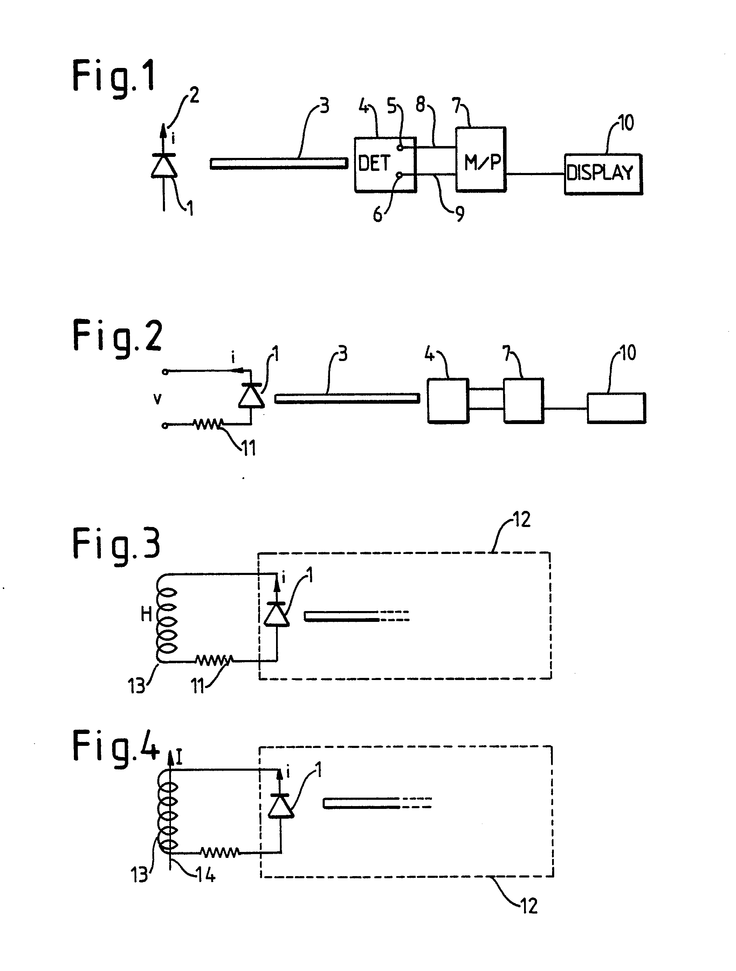

Referring to Figure 1, there is shown a source in the form of a light emitting diode (LED) 1, which is caused to emit by a current i passing through a circuit shown generally at 2. The emitted light is transmitted by means of an optical fibre 3 to a detector 4 comprising two photo-responsive elements 5 and 6. Signals from the photo-responsive elements 5 and 6 are passed to a microprocessor 7 via lines 8 and 9 respectively. The output of the microprocessor 7 is used to drive a digital display 10.

As the current i passing through the light emitting diode 1 changes, the colour of the light emitted thereby changes also. The emitted light reaching the detector 4 impinges on the photo-responsive elements 5 and 6 producing two different output signals, which signals are analysed by the microprocessor 7. The microprocessor 7 calculates the colour of the emitted light in terms of two parameters on the Chromaticity (CIE) Diagram from the signals from the photo-responsive elements 5 and 6. The parameters are then compared with those in a look-up table stored in a read only memory of the microprocessor, and the corresponding value of current is obtained. The magnitude of the current is then displayed by means of the digital display 10.

Figure 2 shows how the apparatus of Figure 1, which is shown with reference numerals as before, can be used to measure a voltage v. The voltage to be measured is applied across a known resistance 11, and the current is used to drive the LED 1. By detecting the colour of the light emitted by the LED as described above, the magnitude of the current i is determined. The value of the voltage v can therefore be calculated by a simple application of Kirchoff's law.

Figure 3 shows how the apparatus of Figure 1, shown generally at 12, is used to measure the strength of a magnetic field H. A search coil 13 is placed in the magnetic field H, and any change in the field induces a current i which is used to drive the LED 1. If the magnetic field is steady and invariable then the coil 13 must be moved in the field e.g. by rotation. The current i produced by the magnetic field is calculated as before by detecting the colour of the light emitted by the LED 1. In this way the magnetic field strength H can be evaluated.

The same apparatus can be used to measure an alternating current I as shown in Figure 4. A wire 14 carrying the alternating current I is placed in, or adjacent the search coil 13. The change in magnetic field produced by the alternating current is detected as described previously with reference to Figure 3, and in this way the magnitude of the current I can be determined.

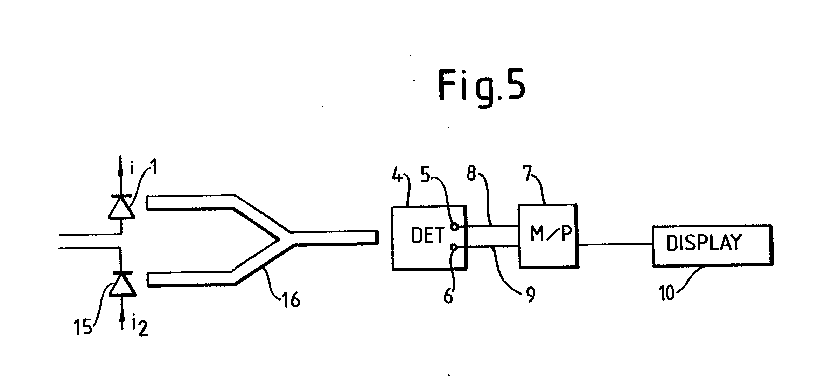

Figure 5 shows an alternative embodiment of apparatus in which more than one light emitting diode is employed as a current responsive source. Light emitting diode 1 is shown as before with the current i to be measured passing therethrough. In addition a second light emitting diode 15 is provided, with a constant current $i_2$ passing therethrough. The light emitted by the two LEDs 1 and 15 is combined in an optical coupler 16 before impinging on a detector 4 exactly as previously described with reference to Figure 1. As the current i passing through LED 1 changes, the colour of the light emitted thereby and hence the light impinging on the detector changes also. The colour of this light is determined exactly as before to give an indication of the magnitude of the current i.

It will be appreciated that other arrangements in addition to those in Figures 1 - 5 can be employed. The apparatus can be employed to detect any parameter which can be translated into an electric current.

## Claims

1. Apparatus for measuring the magnitude of an electric current characterised in that it comprises a source (11) through which the current to be measured is passed, the source (1) being caused to emit polychromatic light in response to the passage of the current, the source being such that the distributed spectral content of the emitted polychromatic light is dependent on the magnitude of the current being passed therethrough; a detector (4) disposed such that at least some of the emitted polychromatic light is incident thereon, the detector (4) being adapted to detect the intensity of the incident light at a plurality of different wavelengths; and analysis means (7) for interpreting the output of the detector in terms of the current passing through the source.

2. Apparatus according to Claim 1 characterised in that the detector (4) is adapted to monitor the ratio of incident light intensities at two or more separate predetermined wavelengths.

3. Apparatus according to Claim 1 characterised in that the detector (4) comprises at least first and second photo-responsive elements (5,6), the responsivity with respect to wavelength of the first element (5) being different from that of the second (6), signals from the photo-responsive elements being fed to the analysis means (7) which calculates, from the signals from the photo-responsive elements (5,6), the colour of the polychromatic light incident on the detector (4) as represented by two or more parameters on the Chromaticity (CIE) Diagram.

4. Apparatus according to any of Claims 1 to 3 characterised in that the source is a light emitting diode (1).

5. Apparatus according to any of Claims 1 to 3 characterised in that the source comprises a plurality of light emitting diodes (1,15) and an optical coupler (16).

6. Apparatus according to any of Claims 1 to 5 characterised in that there is provided a display unit (10) actuated by an output signal produced bythe analysis means.

7. Apparatus according to any of Claims 1 to 6 characterised in that an optical fibre (3) is provided between the source (1) and the detector (4).

8. A method of measuring the magnitude of an electric current characterised by the steps of passing the electric current through a source (1) so as to cause the source to emit polychromatic light; detecting the intensity of the emitted polychromatic light at a plurality of different wavelengths; and interpreting the detected intensity of the emitted polychromatic light in terms of the electric current passing through the source (1).

9. A method according to Claim 8 characterised by the step of monitoring the ratio of incident light intensities at two or more separate predetermined wavelengths.

10. A method according to Claim 8 characterised by the steps of detecting the emitted polychromatic light with a detector (4) comprising at least first and second photo-responsive elements (5,6), the responsivity with respect to wavelength of the first element (5) being different from that of the second (6); calculating, from the output of the first and second photo-responsive elements, the colour of the emitted polychromatic light as represented by two or more parameters on the Chromaticity (CIE) Diagram; and interpreting the colour of the emitted polychromatic light in terms of the electric current passing through the source.

Fig.1

Fig.2

Fig.3

Fig.4

# Fig.5

0 284 214

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | DE-A-3 039 471 (ASEA)<br>* Claims 1,3; figures 8,9; page 15, line 15 - page 16, line 4 *<br>--- | 1-10 | G 01 R 15/07 |
| A | US-A-4 630 218 (COOPER)<br>--- | | |
| A | EP-A-0 175 358 (MITSUBISHI)<br>----- | | |

**TECHNICAL FIELDS SEARCHED (Int. Cl.4)**

G 01 R

The present search report has been drawn up for all claims

| Place of search | Date of completion of the search | Examiner |
|---|---|---|
| THE HAGUE | 07-06-1988 | HOORNAERT W. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

 

& : member of the same patent family, corresponding document

EPO FORM 1503 03.82 (P0401)